# DEMANDE DE BREVET EUROPEEN

(11) **EP 2 290 703 A1**
(43) Date de publication de la demande: **02.03.2011**
(21) Numéro de dépôt: 10008786.5
(22) Date de dépôt: 24.08.2010
(51) Int. Cl.: H01L 31/052

(54) **Concentrateur de l'energie solaire comprenant miroir auto-radiants**

(30) Priorité: 24.08.2009 FR 0904033
(71) Demandeur: SUNPARTNER, 13545 Aix-en-Provence Cedex 4 (FR)
(72) Inventeur: Gilbert, Joel, 13410 Lambesc (FR)
(74) Mandataire: Schmidt, Martin Peter

(57) **Abrégé**

Concentrateur de l'énergie solaire comportant
- au moins deux premier et deuxième miroirs (1) M1,M2 paraboliques ou/et cylindro-paraboliques, qui sont positionnés de sorte que leurs faces concaves soient en face à face, et de sorte que les rayons solaires incidents R1 qui se réfléchissent sur le premier miroir M1 se concentrent sur le deuxième miroir M2, et que les rayons solaires R2 qui se réfléchissent sur le deuxième miroir M2 se concentrent sur le premier miroir M1,
- et au moins deux premier et deuxième capteurs solaires (9) C1,C2,
**caractérisé en ce que**
- au moins un premier capteur solaire C1 est positionné à la surface du premier miroir M1, à l'emplacement de son point focal et/ou de sa ligne focale, et
- au moins un deuxième capteur solaire photovoltaïque C2 est positionné à la surface du deuxième miroir M2, à l'emplacement de son point focal et/ou de sa ligne focale,

et **caractérisé en ce que** les faces actives desdits capteurs solaires C1,C2 sont orientées vers le miroir opposé.

## Description

### Domaine technique de l'invention

La présente invention se rapporte aux dispositifs capteurs solaires à concentration destinés à être utilisés à l'extérieur, et plus particulièrement aux capteurs photovoltaïques.

### Etat de la technique

On connaît des concentrateurs solaires, qui utilisent des miroirs, des lentilles ou des fibres optiques pour concentrer le rayonnement solaire sur un capteur solaire. Ce capteur solaire peut être un capteur photovoltaïque, c'est-à-dire un capteur qui absorbe au moins une partie du rayonnement solaire pour transformer son énergie en énergie électrique, par exemple une cellule photovoltaïque. Ce capteur peut aussi être un capteur thermique, i.e. un capteur qui absorbe au moins une partie du rayonnement solaire pour transformer son énergie en énergie thermique ; un tel capteur présente en général une surface absorbante parcourue par un liquide caloporteur. A titre d'exemple, on connaît des concentrateurs solaires comportant au moins un miroir possédant une surface de collecte relativement grande, et qui renvoie le rayonnement solaire sur une surface de capteur plus petite. Ainsi, on peut utiliser des capteurs plus petits.

Un des problèmes associés aux concentrateurs solaires à capteur photovoltaïque est que la concentration de la lumière visible sur la surface du capteur photovoltaïque va de pair avec une concentration de chaleur ; or, l'augmentation de la température d'un capteur photovoltaïque conduit à la baisse de son rendement de conversion de la lumière.

Le procédé utilisé couramment pour dissiper les calories générées par la concentration solaire sur la cellule est d'y associer un radiateur soit passif, qui dissipe les calories au contact de l'air (typiquement par convection et / ou rayonnement), soit hydraulique qui dissipe les calories dans un liquide de transfert en circulation dans un échangeur thermique. Ces radiateurs sont souvent constitués de profilés en aluminium, un métal léger présentant un coefficient de conductivité thermique très élevé. Ils alourdissent le dispositif et ne sont utilisés que si leur coût est inférieur au gain qu'ils procurent en termes de production d'électricité.

L'état de la technique présente de nombreuses formes de concentrateurs. Ainsi, US 3,923,381 (R. Winston) décrit un concentrateur constitué de deux éléments réfléchissants de forme parabolique disposés face à face, et qui renvoient le rayonnement vers un capteur thermique sous la forme d'un tube situé à la jonction entre ces deux éléments réfléchissants.

US 4,153,474 (Erno Raumfahrttechnik GmbH) décrit un collecteur d'énergie solaire à concentration comprenant une pluralité de miroirs ayant chacun une surface avant et une surface arrière, lesdits miroirs étant disposés de manière à ce que la zone focale de la surface avant réfléchissante d'un premier miroir soit proche d'une partie de la surface arrière d'un second miroir adjacent et qui reçoit le rayonnement solaire focalisé du premier miroir, le miroir portant la cellule solaire ayant en outre une fonction de dissipateur de chaleur. De manière similaire, US 5,180,441 (General Dynamics Corp.) décrit un panneau solaire photovoltaïque constitué de miroirs paraboliques adjacents comportant sur leur face convexe des cellules photovoltaïques. Les miroirs sont disposés de manière à ce que la ligne focale d'un miroir soit située sur la surface arrière du miroir adjacent, les cellules photovoltaïques étant placées sur cette ligne focale et recevant la lumière focalisés. Les miroirs assurent une fonction de dissipateur thermique. US 5,344,496 (General Dynamics Corp.) résout le problème de fixation mécanique des miroirs dans ce système, en les intégrant dans un boîtier. Dans tous ces systèmes, les cellules solaires ne sont pas dirigées vers le haut et ne peuvent pas capter de manière efficace la lumière diffuse.

Le brevet EP 1 287 300 (S. Frazier) décrit un concentrateur solaire comprenant une surface de réflexion primaire, qui est la portion d'une surface parabolique ayant une ligne focale associée et un plan directeur, et une surface de réflexion secondaire, dans lequel concentrateur lesdites surfaces de réflexion primaire et secondaire sont reliées, et la surface de réflexion secondaire est plane et positionnée entre la ligne focale et la surface de réflexion primaire de sorte quE la lumière incidente réfléchie de la surface de réflexion primaire vers la ligne focale est réfléchie de la surface de réflexion secondaire à une ligne focale secondaire sur la surface parabolique.

La demande de brevet WO 03/019083 (Solar Roof Int.) décrit un concentrateur solaire comportant au moins trois réflecteurs. Un réflecteur primaire concave reçoit le rayonnement solaire et l'envoie sur un second réflecteur convexe positionné dans la zone focale du premier réflecteur. A son tour, le second réflecteur envoie le rayonnement solaire sur un troisième réflecteur positionné dans la zone focale du second réflecteur. Ce dispositif permet de produire de la vapeur.

Le document US 2009/0056785 (Skyline Solar Inc.) décrit un collecteur comprenant
- une pluralité de panneaux réflecteurs, une structure qui supporte lesdits panneaux de manière former une paire d'auges adjacentes, chaque auge ayant une base, une paire de parois réfléchissantes et une ouverture appropriée pour recevoir le rayonnement solaire ;
- une pluralité de capteurs solaires photovoltaïques, chacun des capteurs étant adjacent d'un bord d'une auge associée, placés au sommet des auges pour éviter de faire d'ombre aux panneaux réflecteurs).

Dans ce système, les panneaux réflecteurs sont agencés de manière à diriger le rayonnement solaire incident vers le capteur solaire en utilisant une réflexion unique. Les cellules photovoltaïques sont refroidies grâce à des puits de chaleur situés derrière les capteurs photovoltaïques.

L'article « Design, Construction and Measurement of a Single-Mirror Two-Stage (SMTS) Photovoltaic Concentrator » par E. Arlarte et al., paru dans 2nd World Conference and Exhibition on Photovoltaic Solar Energy Conversion, Wien, Juillet 1998, p. 2245-2247, décrit un concentrateur à surfaces non analytiques dans lequel les cellules photovoltaïques sont positionnées au-dessus de la surface des miroirs. Un radiateur est prévu pour refroidir ces cellules.

Le problème que la présente invention cherche à résoudre est de présenter un concentrateur solaire, de conception simple et compatible avec des capteurs solaires photovoltaïques, qui présente un haut degré de collecte de la lumière directe et diffuse, et qui est capable de dissiper un maximum d'énergie thermique, de préférence sans avoir besoin d'ajouter au capteur photovoltaïque une structure dissipative propre (radiateur) qui alourdit sa conception et sa masse et qui augmente son coût.

### Objets de l'invention

### L'invention concerne un concentrateur de l'énergie solaire comportant

- une pluralité de miroirs paraboliques et/ou cylindro-paraboliques, et plus précisément au moins deux premier et deuxième miroirs paraboliques ou/et cylindro-paraboliques qui sont positionnés de sorte que leurs faces concaves soient en face à face, et de sorte que les rayons solaires incidents qui se réfléchissent sur le premier miroir se concentrent sur le deuxième miroir et que les rayons solaires qui se réfléchissent sur le deuxième miroir se concentrent sur le premier miroir, - et au moins deux premier et deuxième capteurs solaires, **caractérisé en ce que**
- au moins un premier capteur solaire est positionné à la surface du premier miroir, à l'emplacement de son point focal et/ou de sa ligne focale, et
- au moins un deuxième capteur solaire est positionné à la surface du deuxième miroir, à l'emplacement de son point focal et/ou de sa ligne focale, et **caractérisé en ce que** les faces actives desdits capteurs solaires sont orientées vers le miroir opposé. Avantageusement, les premier et deuxième miroirs sont conçus et disposés de manière à ce que les rayons solaires se concentrent au centre des miroirs, et en ce que capteurs solaires sont positionnés respectivement au centre des premier et deuxième miroirs.

Dans un mode de réalisation, lesdits capteurs solaires sont des capteurs photovoltaïques (cellules photovoltaïques) ou des capteurs thermiques. Dans une variante de ce mode de réalisation, lesdites cellules photovoltaïques peuvent être refroidies par une circulation de liquide sur ou sous la face non active desdites cellules.

Lesdits cellules photovoltaïques sont avantageusement fixées sur la surface du miroir, de préférence par collage.

Dans un mode de réalisation particulier, lesdits capteurs photovoltaïques sont refroidis par un radiateur positionné sur la face arrière dudit miroir, derrière ledit capteur photovoltaïque.

Un autre objet de l'invention est un dispositif de concentration d'énergie solaire, **caractérisé en ce qu**'il est constitué d'au moins deux concentrateurs selon l'invention, et en ce que ces aux moins deux concentrateurs sont juxtaposés les uns aux autres de sorte que leurs axes longitudinaux sont tous parallèles.

Dans un mode de réalisation particulier, ce concentrateur ou ce dispositif comporte un axe de rotation vertical permettant de suivre la direction du soleil. L'angle formé par les axes longitudinaux desdits miroirs avec l'horizontale est fixe lors du fonctionnement dudit dispositif, et compris entre 35° et 90°.

Encore un autre objet de l'invention est un procédé d'utilisation d'un concentrateur ou dispositif tel que décrit ci-dessus, comprenant les étapes suivantes :
(a) on fixe l'angle formé par les axes longitudinaux desdits miroirs avec l'horizontale à une valeur fixe comprise entre 35° et 90° ;
(b) lors du fonctionnement dudit dispositif, on fait tourner, de manière continue ou discontinue, ledit concentrateur autour de l'axe de rotation vertical de manière à ce que lesdits miroirs M1,M2 se trouvent exposées face au soleil.

### Figures

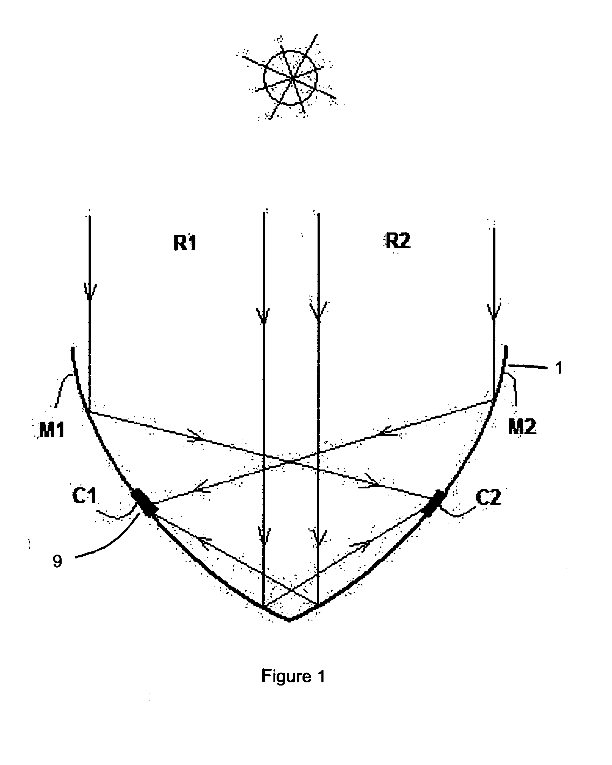

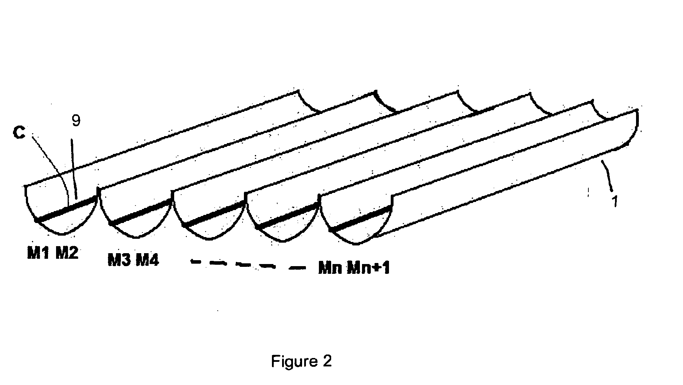

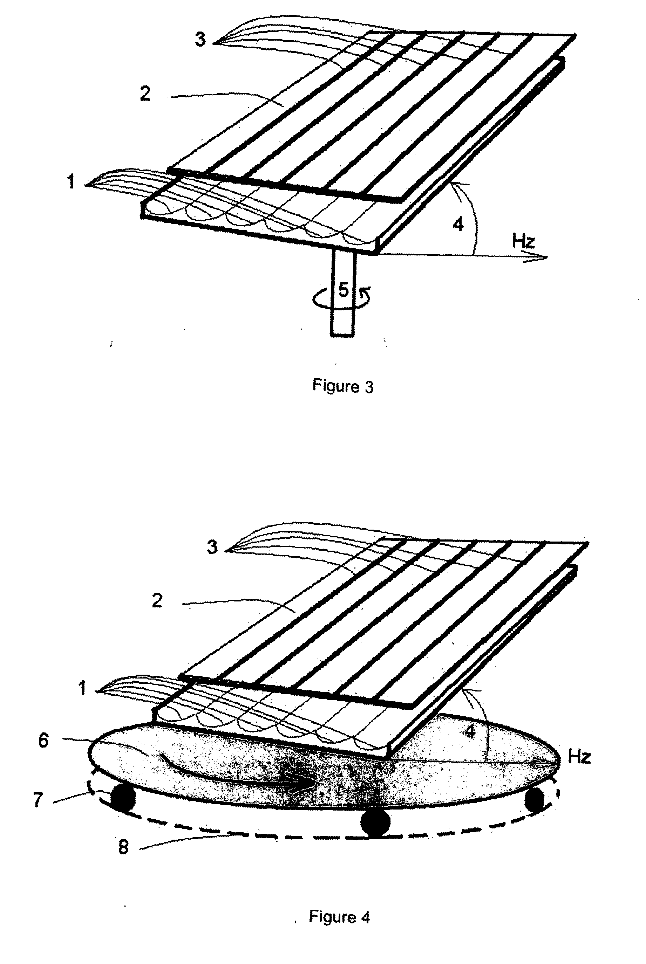

Les figures 1 à 4 illustrent l'invention, mais ne la limitent pas. La figure 1 représente en coupe le dispositif de l'invention et illustre le principe de l'invention. La figure 2 représente un mode de réalisation du dispositif selon l'invention pour former panneau solaire. Les figures 3 et 4 montrent deux autres modes de réalisation du dispositif selon l'invention, avec un système de suivi du soleil.

### Description détaillée

On entend ici par « capteur solaire » un convertisseur de l'énergie solaire en énergie électrique, thermique ou chimique.

On entend ici par « concentrateur solaire » un système optique capable de concentrer l'énergie du soleil à l'aide d'au moins un miroir.

On entend ici par « miroir » une surface réfléchissante, métallique ou non métallique.

On entend ici par « suiveur de soleil » un dispositif mécanique capable d'orienter le capteur solaire vers le soleil et de suivre le mouvement relatif du soleil.

Le système concentrateur solaire selon l'invention est constitué d'une pluralité de miroirs, de préférence identiques, et plus précisément d'au moins deux premier et deuxième miroirs **1** (M1, M2), qui sont utilisés à la fois pour focaliser le rayonnement solaire sur les capteurs solaires, qui peuvent être des cellules photovoltaïques, et comme radiateurs thermiques, capables de dissiper l'énergie thermique apportée par le rayonnement solaire et de refroidir ainsi les capteurs solaires **9** (C1,C2). Lesdits miroirs **1** M1,M2 peuvent être réalisées en tôles métalliques, par exemple en tôle d'aluminium, qui, du fait de leur grande surface en contact avec l'air et de leur bonne conductivité thermique, favorisent les échanges thermiques et peuvent donc servir de radiateurs efficaces. De manière moins préférée, on peut utiliser des matériaux non-métalliques revêtus d'une surface réfléchissante, typiquement d'un film métallique. Les miroirs selon l'invention ont donc deux fonctions, celle de réfléchir le rayonnement solaire pour le concentrer sur le capteur, et celle de refroidir le capteur par conduction thermique. Cette double fonction est rendue possible en positionnant deux miroirs **1** M1,M2 face à face, et en positionnant les capteurs solaires **9** C1,C2, tels que des cellules solaires photovoltaïques, directement sur la surface du miroir M1,M2, à l'emplacement de son point focal ou de sa ligne focale.

Plus précisément, le système concentrateur solaire selon l'invention (Figure **1**) comporte au moins deux premier et deuxième miroirs paraboliques et/ou cylindro-paraboliques **1** M1,M2, de préférence identiques, disposés l'un par rapport à l'autre de manière à ce que le point ou la ligne focal de l'un se situe à la surface de l'autre miroir et réciproquement. Ce but est atteint avec deux premier et deuxième miroirs paraboliques identiques M1,M2 disposés l'un en face de l'autre avec leur face concave en face à face ; les rayons solaires incidents R1 qui se réfléchissent sur le premier miroir M1 se concentrent au centre du deuxième miroir M2 et réciproquement les rayons solaires R2 qui se réfléchissent sur le deuxième miroir M2 se concentrent au centre du premier miroir M1.

Sur la surface de chacun des deux miroirs **1** M1,M2, à l'emplacement du point ou de la ligne focale, est positionné le capteur solaire **9** C1,C2. Chaque capteur solaire C1,C2 est positionné avec sa face active tournée vers le miroir opposé, et sa face arrière (ou face non-active) est fixée au miroir d'une manière qui assure un bon contact thermique. A titre d'exemple, on peut coller la surface non-active du capteur solaire M1,M2 sur la surface du miroir avec une colle qui résiste à la température maximale de fonctionnement du système, soit typiquement 150°C, et dont le coefficient de transmission thermique est avantageusement supérieur à 6 W/m² K.

Les capteurs solaires C1,C2 sont positionnés de préférence au centre des miroirs M1,M2 de manière à favoriser la diffusion de la chaleur sur toute la surface des miroirs. Les miroirs M1,M2 soient donc avantageusement choisis de manière à ce que le point ou la ligne focale soit au centre de la surface dudit miroir. Cela permet que la chaleur concentrée sur les cellules photovoltaïques C1,C2 sous concentration solaire C1 et C2 soit dissipée au mieux par les miroirs M1,M2 au contact de l'air ; ainsi les miroirs agissent comme dissipateur thermique.

Typiquement, les capteurs solaires **9** C1,C2 sont des capteurs photovoltaïques (par exemple en silicium monocristallin ou polycristallin). Dans un mode de réalisation particulier, non illustré, les cellules photovoltaïques. C1,C2 sont remplacées par des capteurs solaires thermiques, par exemple des tubes à l'intérieur desquels circule un liquide caloporteur. Dans ce cas la majorité des calories sont absorbées par le liquide et les miroirs ne jouent que le rôle de concentrateur optique du rayonnement solaire et non plus le rôle de dissipateur de chaleur. Le but de cette dernière réalisation étant de produire de l'eau chaude d'origine solaire.

Dans un autre mode de réalisation, non illustré, les cellules photovoltaïques C1,C2 sont refroidies de manière additionnelle par un radiateur fixé, par exemple par collage avec une colle comme décrite ci-dessus, sur la face du miroir non exposée au rayonnement solaire, derrière ladite cellule photovoltaïque. Ce radiateur peut être un radiateur de type connu, par exemple un profilé d'aluminium pourvu d'ailettes. On peut même ajouter un système de refroidissement par liquide caloporteur, si cela s'avère nécessaire ou utile.

Dans un autre mode réalisation, illustré sur la figure 2, un panneau solaire est constitué par la juxtaposition de plusieurs systèmes concentrateur solaire selon l'invention, ceux-ci étant tous identiques ou/et en partie différents, ces derniers étant choisis parmi les modes de réalisation précédemment cités.

Plus précisément, au moins deux dispositifs composés de miroirs **1** cylindro-paraboliques M1M2, M3M4 MnM(n+1) sont juxtaposés les uns à côté des autres de sorte que leurs axes longitudinaux soient parallèles.

Dans un mode de réalisation ou d'utilisation très avantageux d'un concentrateur de l'énergie solaire selon l'invention, on oriente, en permanence ou au moins de manière périodique, i.e. plusieurs fois au cours de la journée, le concentrateur solaire vers le soleil afin que les capteurs solaires restent toujours dans la zone focale des miroirs M1,M2 en opposition. Dans ce but, on utilise un suiveur de soleil (« tracker » en anglais) uniaxial. Ce système est décrit en détail ci-dessous.

D'une manière générale, le suivi du soleil par un concentrateur de l'énergie solaire nécessite d'une part de positionner initialement l'axe longitudinal des miroirs par rapport à l'horizon (la déclinaison) et par rapport au Sud (l'angle azimutal), et d'autre part de faire pivoter les miroirs autour d' un ou deux axes bien définis pour suivre le soleil. Le choix du positionnement initial de l'axe longitudinal des miroirs et le choix des axes de pivotement sont déterminés de manière à obtenir le maximum de capture du rayonnement solaire avec le minimum d'inconvénients, notamment d'ordre mécanique, et le minimum de coût. Les principaux inconvénients rencontrés sont les suivants :
(1) L'inconvénient d'utiliser deux axes de pivotement à la place d'un seul. Cela engendre un surcoût dû à une mécanique plus importante, donc plus chère, et engendre une augmentation du risque de panne dû à une mécanique plus complexe.
(2) L'inconvénient d'un axe de pivotement non vertical. Le choix d'un axe de pivotement incliné, par exemple suivant l'axe de rotation de la terre, ou horizontal, par exemple suivant l'axe Est / Ouest, implique que la répartition des charges, notamment dues au poids des miroirs, autour de cet axe et pendant le suivi du soleil, se modifie ; cela entraine la nécessité d'une structure porteuse plus robuste donc plus chère.
(3) L'ombre d'un miroir ne doit pas tomber sur un autre miroir proche. Pour éviter cela les miroirs cylindro-paraboliques doivent être suffisamment espacés les uns des autres. La distance de cet espacement dépend des dimensions du miroir, notamment de sa largeur. Or le fait d'espacer les miroirs implique soit d'utiliser un système de pivotement individuel de chaque miroir, soit d'utiliser une mécanique de transmission du système de pivotement pour plusieurs miroirs à la fois. L'un et l'autre de ces deux choix augmentent le coût d'un ensemble de concentrateurs solaires. On a donc intérêt à rechercher une répartition des miroirs les uns par rapport aux autres qui les rapprocherait le plus possible sans qu'ils se fassent de l'ombre.
(4) Les miroirs ont des surfaces fragiles qui doivent être protégées des intempéries par un traitement de surface approprié. On peut utiliser une plaque de verre transparente pour protéger le miroir. Mais cela alourdit le système et n'est envisageable qu'avec un système dont la répartition des charges reste stable même pendant le suivi du soleil.

Le dispositif selon l'invention, permet de remédier à ces quatre inconvénients principaux. En effet il comporte un axe de pivotement vertical unique 5 qui est aussi l'axe de suivi du soleil. Le dispositif selon l'invention résout donc l'inconvénient N° (1) et N° (2) indiqué ci-dessus dans la mesure où il ne possède qu'un seul axe de rotation et que celui-ci est vertical. Le dispositif comporte une juxtaposition de miroirs cylindro-paraboliques **1** identiques dont les axes longitudinaux sont tous parallèles et forment avec le plan horizontal un angle **4** fixe compris entre 35° et 90°. Pour une latitude géographique donnée, cet angle est réglé une fois pour toutes et n'a pas besoin d'être ajusté lors du fonctionnement normal du dispositif.

Cette structure permet d'avoir des largeurs de miroirs faibles, par exemple inférieures à 15 cm ; cela résout l'inconvénient N° (3) indiqué ci-dessus. Comme les miroirs **1** sont juxtaposés et font continuellement face au soleil, aucun d'entre eux ne fera d'ombre à l'un quelconque des autres miroirs. Avantageusement, les miroirs sont positionnés de telle sorte qu'ils sont les plus proches possible les uns des autres.

Par ailleurs, le dispositif selon l'invention peut comporter une plaque transparente **2** qui recouvre l'ensemble des miroirs **1**. Elle protège les miroirs des intempéries ; le surpoids qu'elle engendre est acceptable car l'ensemble du dispositif est monté et pivote sur un axe de rotation vertical unique **5** qui stabilise la répartition des charges sur cet axe même pendant le suivi du soleil. Cela résout l'inconvénient N° (4) indiqué ci-dessus.

Le suiveur de soleil uniaxial a été décrit ci-dessus en combinaison avec un dispositif comprenant au moins deux concentrateurs selon l'invention, mais il peut être utilisé également avec un seul concentrateur selon l'invention.

Selon un mode de réalisation particulier de l'invention, l'axe de rotation vertical **5** est réalisé sous la forme d'un cercle ou disque horizontal **6** mobile autour d'un axe vertical situé en son centre; sur ce cercle ou disque **6** est fixé un ensemble de roues **7** qui prennent appuis sur le sol 8.

Les figures 3 et 4 illustrent deux variantes de ce mode de réalisation de l'invention : En référence à ces figures, le dispositif comporte une juxtaposition de miroirs cylindro-paraboliques identiques **1** dont les axes longitudinaux sont tous parallèles. Une plaque de verre transparente **2,** optionnelle, recouvre les miroirs. L'axe longitudinal des miroirs est incliné d'un angle **4** compris entre 35° et 90° par rapport à l'horizontale (Hz). L'ensemble du dispositif est mobile autour d'un axe vertical **5.**

Selon une variante (Figure 4) le dispositif est fixé sur un disque horizontal **6** ou un cercle horizontal (non représenté) qui est mobile autour d'un axe de rotation vertical situé en son centre, et qui prend appui sur le sol **8** par l'intermédiaire d'un ensemble de roues **7.**

A titre d'exemple non limitatif le dispositif comprend six miroirs cylindro-paraboliques en opposition de 20 cm de large et 1,5 m de longueur. Une plaque de verre transparente de 5 mm d'épaisseur est fixée sur l'ensemble des miroirs. L'angle d'inclinaison des miroirs par rapport à l'horizontal vaut 35°. Le tout est fixé sur un axe de rotation vertical métallique de 10 cm de diamètre muni d'un système électromécanique de rotation et de suivi du soleil. Selon un mode de réalisation particulier le dispositif est fixé sur une roue métallique de 2 m de diamètre mobile autour d'un axe de rotation vertical placé en son centre, cette roue repose sur le sol par un ensemble de quatre roues de 10 cm de diamètre.

Le dispositif selon l'invention permet d'améliorer l'efficacité et de réduire le coût de systèmes photovoltaïques à concentration. En effet, la demanderesse a constaté que l'utilisation du dispositif selon l'invention conduit à une température d'équilibre de la cellule photovoltaïque significativement plus basse, sous une irradiation solaire donnée, qu'un dispositif concentrateur selon l'état de la technique ; cette diminution de la température d'équilibre s'accompagne d'une augmentation du rendement de conversion de la lumière en puissance électrique.

### Exemple 1 :

Cet exemple illustre l'effet de dissipation de la chaleur d'un miroir. On a utilisé pour ces essais un miroir plat en tôle d'aluminium brillant, d'épaisseur 0,5 mm, de dimension 20 cm x 100 cm. Ce miroir a été placé à plat (horizontalement) sur un support, à l'extérieur, à une température de l'air de 25°C, sous un éclairage solaire de 200 W (correspondant à 1000 W/m²). Une photopile sous la forme d'une bande de 20 cm de long et de 1,5 cm de large a été fixée sur la surface éclairée du miroir, parallèle au bord court du miroir, à savoir dans l'exemple 1A directement au bord, dans l'exemple 1B au milieu. On a déterminé la température d'équilibre de la photopile pour différentes vitesses du vent. Les résultats suivant ont été obtenus :

### Exemple 1A : photopile au bord du miroir

| | | | | | |
|---|---|---|---|---|---|
| Vitesse de l'air [m/s] | 0 | 2 | 4 | 8 | 16 |
| Température de la photopile [°C] | 220 | 172,5 | 147,5 | 127,5 | 110,5 |

### Exemple 1 B : photopile au centre du miroir

| | | | | | |
|---|---|---|---|---|---|
| Vitesse de l'air [m/s] | 0 | 2 | 4 | 8 | 16 |
| Température de la photopile [°C] | 129 | 88 | 77 | 68,5 | 61,5 |

On voit l'effet très significatif que joue le miroir dans le refroidissement de la photopile, si cette dernière est posée directement sur la surface du miroir, c'est-à-dire en contact thermique direct avec celle-ci ; cet effet est optimal si la photopile est située au centre du miroir.

Cet effet dissipatif du miroir est illustré également par l'étude de l'influence de l'épaisseur du miroir sur son effet dissipatif : avec la même configuration que décrite ci-dessus pour l'exemple 1 B, on a fait varier l'épaisseur du miroir. On a trouve par exemple que pour qu'une vitesse du vent de 0 m/s, la température d'équilibre de la photopile diminue de 129,5 à 113,5°C lorsque l'épaisseur passe de 0,5 mm à de 1 mm. Pour une vitesse du vent de 16 m/s, elle diminue de 60°C à 50°C, et pour une épaisseur de 2 mm, elle est descend même jusqu'à 43,5 °C.

### Exemple 2 :

On a réalisé un dispositif selon l'invention comprenant deux miroirs cylindro-paraboliques M1,M2, en aluminium de 0,5 mm d'épaisseur, de 20 cm de largeur, de 14 cm de longueur focale et de 125 cm de longueur. Les miroirs ont été placés avec leur face concave tournée l'une vers l'autre, leur section transversale forme entre elles un angle de 90 degrés. Au centre de chaque miroir a été collé un capteur photovoltaïque de 15 mm de largeur et de 100 cm de longueur. La colle utilisée était une colle résistant à des températures supérieure à 150°C et qui présentait un très bon coefficient de transmission thermique (supérieur à 6 W/m² K) de manière à transmettre efficacement la chaleur du capteur vers le miroir qui joue alors le rôle de radiateur.

On a mesuré la température du capteur photovoltaïque, qui était de 57°C, et celle de l'air ambiant qui était de 22°C.

On a ensuite réalisé le même dispositif que décrit ci-dessus, mais au lieu d'utiliser une colle comme décrite, on a utilisé une feuille en matière thermiquement très isolante. On a constaté que dans les mêmes conditions de mesure, la température du capteur photovoltaïque est monté jusqu'à 78°C. On a observé une baisse du rendement du capteur par rapport à la variante avec la colle thermiquement conductrice.

## Revendications

1. Concentrateur de l'énergie solaire comportant
- au moins deux premier et deuxième miroirs (1) M1,M2 paraboliques ou/et cylindro-paraboliques, qui sont positionnés de sorte que leurs faces concaves soient en face à face, et de sorte que les rayons solaires incidents R1 qui se réfléchissent sur le premier miroir M1 se concentrent sur le deuxième miroir M2, et que les rayons solaires R2 qui se réfléchissent sur le deuxième miroir M2 se concentrent sur le premier miroir M1,
- et au moins deux premier et deuxième capteurs solaires (9) C1,C2,
**caractérisé en ce que**
- au moins un premier capteur solaire C1 est positionné à la surface du premier miroir M1, à l'emplacement de son point focal et/ou de sa ligne focale, et
- au moins un deuxième capteur solaire photovoltaïque C2 est positionné à la surface du deuxième miroir M2, à l'emplacement de son point focal et/ou de sa ligne focale,
et **caractérisé en ce que** les faces actives desdits capteurs solaires C1,C2 sont orientées vers le miroir opposé.

2. Concentrateur selon la revendication 1, **caractérisé en ce que** les premier et deuxième miroirs (1) M1,M2 sont conçus et disposés de manière à ce que les rayons solaires R1 et R2 se concentrent au centre des miroirs (1) M1 et M2, et **en ce que** les premier et deuxième capteurs solaires (9) C1,C2 sont positionnés respectivement au centre desdits premier et deuxième miroirs (1) M1,M2.

3. Concentrateur selon la revendication 1 ou 2, **caractérisé en ce que** lesdits capteurs solaires (9) C1 ,C2 sont des capteurs photovoltaïques ou des capteurs thermiques.

4. Concentrateur selon la revendication 3, **caractérisé en ce que** lesdites capteurs photovoltaïques (9) C1,C2 sont refroidies par une circulation de liquide sur ou sous la face non active desdits capteurs (9) C1,C2.

5. Concentrateur selon l'une quelconque des revendications 1 à 4, **caractérisé en ce que** lesdits premier et deuxième capteurs solaires (9) C1,C2 sont des capteurs photovoltaïques qui sont fixées chacun sur la surface dudit premier et deuxième miroirs (1), respectivement.

6. Concentrateur selon la revendication 5, **caractérisé en ce que** lesdits capteurs photovoltaïques (9) sont fixés sur la surface du miroir(1) par collage.

7. Concentrateur selon la revendication 4 ou 5, **caractérisé en ce que** lesdits capteurs photovoltaïques (9) sont refroidis par un radiateur positionné sur la face arrière dudit miroir (1), derrière ledit capteur photovoltaïque (9).

8. Dispositif de concentration d'énergie solaire, **caractérisé en ce qu'**il est constitué d'au moins deux concentrateurs selon l'une quelconque des revendications 1 à 7, et **en ce que** ces aux moins deux concentrateurs sont juxtaposés les uns aux autres de sorte que leurs axes longitudinaux sont tous parallèles.

9. Concentrateur selon l'une quelconque des revendications 1 à 7 ou dispositif selon la revendication 8, **caractérisé en ce que** ledit concentrateur ou ledit dispositif comporte un axe de rotation vertical (5) permettant de suivre la direction du soleil, et **en ce que** l'angle (4) formé par les axes longitudinaux desdits miroirs (1) avec l'horizontale est fixe lors du fonctionnement dudit concentrateur ou dudit dispositif, et compris entre 35° et 90°.

10. Procédé d'utilisation d'un concentrateur ou dispositif selon la revendication 8 ou 9, comprenant les étapes suivantes :
(a) on fixe l'angle (4) formé par les axes longitudinaux desdits miroirs avec l'horizontale à une valeur fixe comprise entre 35° et 90° ;
(b) lors du fonctionnement dudit dispositif, on fait tourner, de manière continue ou discontinue, lesdits concentrateurs autour de l'axe de rotation vertical (5) de manière à ce que lesdits miroirs (1) M1,M2 se trouvent exposées face au soleil.
